# EUROPEAN PATENT SPECIFICATION

(11) **EP 3 580 810 B1**
(45) Date of publication and mention of the grant of the patent: **19.05.2021**
(21) Application number: 17895995.3
(22) Date of filing: 13.02.2017
(51) Int. Cl.: H01M 10/48, H01M 10/42, H01M 2/10, G01R 31/36, B25F 5/02

(54) **RECHARGEABLE BATTERY PACK**
AKKU
BLOC-BATTERIE RECHARGEABLE

(43) Date of publication of application: 18.12.2019
(73) Proprietor: TTI (Macao Commercial Offshore) Limited, Macao (MO)
(72) Inventor: FAUTEUX, Denis Gaston, Hong Kong (CN); LEE, Hei Man Raymond, Hong Kong (CN)
(74) Representative: Grünecker Patent- und Rechtsanwälte PartG mbB
(86) International application number: PCT/CN2017/073403
(87) International publication number: WO 2018/145324

(56) References cited:
- WO-A1-2017/009637
- JP-A- H07 161 340
- US-A1- 2004 239 293
- US-A1- 2006 164 043
- US-A1- 2012 100 405
- US-A1- 2012 100 405

## Description

### Technical field

The present invention relates to a rechargeable battery pack for a power tool, and particularly a battery pack with a display that indicates operating states of the battery pack.

### Background of the Invention

Rechargeable battery packs may include an illuminated display for displaying a remaining capacity of the battery pack. US8940427 describes a rechargeable battery pack for use with a power tool and which includes a display unit with four LED elements for displaying a remaining capacity and an abnormality of the rechargeable battery. A user-actuable display switch is provided adjacent the display unit for allowing the display unit to receive a command to display a remaining capacity or an abnormal state. When the battery pack is attached to a power tool that is operating, the display is idle unless an abnormal condition occurs. When using a power tool of this type, to provide an indication of the rate at which the battery charge level is dropping, so that a re-charging schedule can be anticipated, it is necessary to regularly press the display switch on the battery pack. When the display switch is spaced apart from the handle of the tool, regularly pressing the display switch in order to show the charge level disrupts the task that the power tool is being used for. It is an object of the present invention to overcome or substantially ameliorate this disadvantage or, more generally, to provide an improved rechargeable battery pack

Furthermore WO 2017/009637 A1 discloses a battery-assisted bicycle (E-bike) having a remaining charge display, which can further indicate the current flow (as an indication of the power output of the motor) when a user actuates a switch.

### Disclosure of the Invention

According to one aspect of the present invention there is provided a rechargeable battery pack attachable to a power tool, the rechargeable battery pack comprising:
a rechargeable battery;
a display comprising an array of segments;
a charge sensor for sensing a charge level of the rechargeable battery;
a display switch that is user-actuable for inputting a first display command;
a current sensor for sensing a current level drawn from the rechargeable battery by the power tool;
an abnormality detector for detecting an abnormal condition of the rechargeable battery; and
a controller operably connected to the display, the charge sensor, the display switch, the current sensor, and the abnormality detector, for controlling a lighted state of the display to progressively light the segments to represent
   i) in a charge display state, a level of charge detected by the charge sensor for a predetermined time, upon receiving the first display command, and
   ii) in a current display state different from the charge display state, a level of current detected by the current sensor,
wherein the current display state is a default state active in the absence of an abnormality detected by the abnormality detector and in the absence of the first display command.

By supplementing the charge display state with a current display state, a user is given an indication of the energy intensity of different tasks, allowing him to better anticipate the remaining run time available for the battery pack.

Preferably the illuminated segments are continuously illuminated in each of the charge display state and the current display state, and the current display state differs from the charge display state in respect of a colour of illumination of each of the segments.

Preferably the array of segments is a substantially linear array; and the progressively lighted segments form a bar graph type display.

Preferably only a first of the segments, located at one end of the substantially linear array, is lighted in both the charge and current display states to indicate, respectively, a low charge level and a low current level. By doing this, the bar graph display always extends in the same direction to indicate an increase in level.

Preferably the display switch is an instantaneous switch and the predetermined time after actuation of the display switch is less than four seconds, and more preferably about two seconds.

Preferably the controller is further arranged to control a lighted state of the segments to represent, in an abnormality display state different from both the current display state and the charge display state, an abnormality condition of the rechargeable battery pack as detected by the abnormality detector; wherein the abnormality display state overrides the charge display state and the current display state.

Preferably the abnormality display state differs from the charge display state and the current display state in respect of a pattern of illumination of the segments.

Preferably the rechargeable battery pack further comprises:
a charge cycle detector for detecting a battery-charging cycle in which battery charge levels are raised between predetermined levels; and
a memory for recording an accumulated number of the battery-charging cycles;
and wherein the display switch is user-actuable for inputting a second display command;
wherein in a cycle display state, different from both the charge display state and the current display state, and upon receiving the second display command, the controller controls the lighted state of the display to progressively light the segments to represent the level of the accumulated number of battery-charging cycles; and the current display state is the default state active in the further absence of the second display command.

Preferably, the abnormality display state overrides the cycle display state.

Preferably the cycle display state differs from the charge display state and the current display state in respect of a colour of illumination of each of the segments.

Preferably only the first of the segments is lighted in the cycle display state to indicate a low accumulated number of battery-charging cycles.

Preferably the controller is arranged to distinguish between the first input command and the second input command based on a duration of actuation of the display switch. The controller may be arranged to determine that the first display command is received upon detecting actuation of the display switch for a first duration, and to determine that the second display command is received upon detecting actuation of the display switch for a second duration above a predetermined threshold duration that is longer than the first duration.

Preferably the rechargeable battery pack is a 58V battery with, for example, a 2Ah or 4Ah capacity.

This invention provides a display for a rechargeable battery pack which can be used not only as a fuel gauge, but also an load gauge automatically indicating the amount of load on the pack and hence the tool to which the pack is attached during normal operation, thereby assisting the operator or user to readily determine the status of the work being performed, and assess the remaining run-time of the battery. This improves safety and operational effectiveness of the battery pack and hence the tool to which the battery pack is attached.

### Brief Description of the Drawings

Preferred forms of the present invention will now be described by way of example with reference to the accompanying drawings, wherein:
Figure 1A is a perspective view of a rechargeable battery pack in accordance with one embodiment of the present invention;
Figure 1B is an end view of the battery pack of Figure 1;
Figure 2 is a block diagram of the main functional components of the battery pack of Figure 1A; and
Figure 3 illustrates the display, in the form of a bar graph, in the battery pack of Figure 1A.

### Description of the Preferred Embodiments

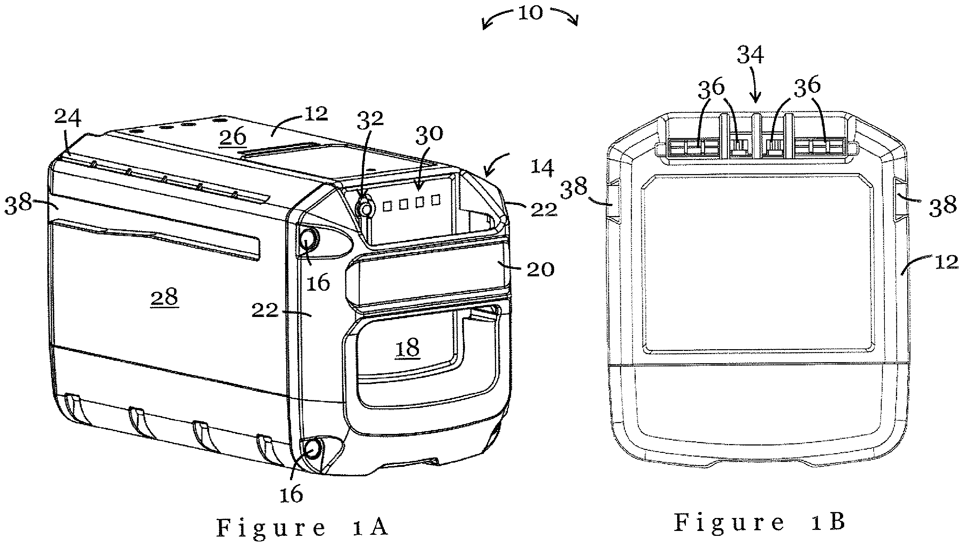

Figures 1A and 1B show a rechargeable battery pack 10 capable of providing power to a power tool (e.g. a blower, a lawn mower, a trimmer), and receiving power from a charger. In this embodiment, the pack 10 has lithium-based chemistry, and has a 58V nominal voltage and 4Ah capacity.

As shown in Figure 1A, the pack 10 includes a generally rectangular prismatic housing 12 (with chamfered or rounded edges). A frame 14 is attached to the front wall 18 disposed at one longitudinal end of the housing 12 by screws 16. The frame 14 is substantially U-shaped and generally extends about three edges of the front wall 18 of the housing 12. The frame 14 further includes a handle part 20 connected across parallel arms 22 of the U-shaped frame 14. The front wall 18 of the housing 12 and the frame 14 are spaced apart, providing a space through which a user may insert his/her hand to grip the handle 20 for carrying the pack 10. Air vents 24 extending from the rear end towards the front end are formed between the top wall 26 and each of the side walls 28 of the housing 12.

The front wall 18 of the housing 12 may include a display 30 formed by, for instance, four segments arranged in a linear array. The four segments each include a window in the housing 12 behind which is a respective one of four multi-colour light sources (e.g., LEDs mounted in a circuit board behind the front wall 18). The window may be translucent, transparent, or cut-out portions of the housing 12 through which light from the light sources can pass. The four segments may each be illuminated independently with different colours (red, green, orange, blue, etc.), either statically or dynamically, at different times for displaying different types of information. The four segments of the display 30 can be progressively lit up from one end toward the other to form a bar graph type display. A display switch 32 is arranged adjacent the display 30 for actuation by the user, allowing the input of different display commands that control the information presented by the display 30. The display switch 32 may be a momentary switch.

Figure 1B shows that the upper part of the rear end of the housing 12 is formed with a port 34 having electric terminals 36. The port 34 is adapted for engaging with a corresponding structure on the power tool, or on a charger, to establish mechanical and electrical connection with the power tool or charger. As is conventional, the connection may be in the form of a plug-and-socket connection. Two guide rails 38, extending substantially horizontally from the rear end of the housing 12 towards the front end, are arranged on the side walls 28 of the housing 12. The rails 38 are arranged for engaging with corresponding structures on the power tool or charger for facilitating engagement of the pack 10 with the tool or the charger. Optionally, a latching mechanism (not shown) may be provided in the power tool or charger for securing the pack 10 to the tool or charger.

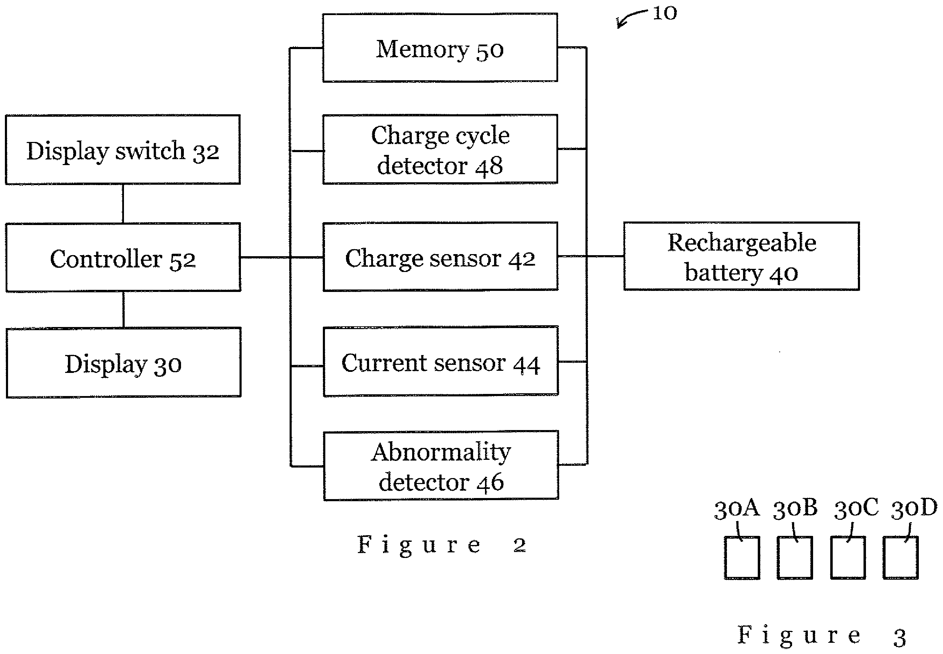

Figure 2 illustrates the main functional components contained in the pack 10 of Figures 1A and 1B. As shown in Figure 2, the rechargeable battery pack 10 includes a rechargeable battery 40 as formed by multiple cells. A charge sensor 42 is connected with the battery 40 for sensing its charge level, i.e., its remaining power in the form of voltage. A current sensor 44 is connected with the battery 40 for sensing a current level drawn from the battery 40, for example, by use of the power tool to which the pack 40 is coupled. An abnormality detector 46 is also provided, connected with the battery 40 for detecting an abnormal condition of the battery 40. The abnormality detector 46 may include one or more sensors operable to detect one or more of the following conditions related to the battery pack 10: communication failure, over-load, over-discharge, over-heat, under-temperature, short circuit, tool incompatibility, charger incompatibility, etc. The pack 10 may further include a charge cycle detector 48 operably connected with the battery 40 for detecting a battery-charging cycle in which battery charge levels are raised between predetermined levels, and a memory 50 for recording an accumulated number of the battery-charging cycles.

It will be understood that the abnormality detector 46 in Figure 2, whilst described as a separate functional module, may be implemented with different electronic components, independently of or in combination with the detector/sensor/controller shown in Figure 2. In one example, the abnormality detector 46 may be a detector having its corresponding controller in communication with the controller 52 of the pack. In another example, the abnormality detector 46 may be part of the controller 52 that detects abnormal signals from the respective sensors and detectors connected thereto. Alternatively, the abnormality detector 46 may be implemented by a corresponding detector and the controller 52. In this case, the controller 52 may be operable to detect the abnormality based on a measurement obtained by the corresponding detector. In an example where the detector 46 is a temperature sensor for detecting temperature of the battery 40, the controller 52 is operable to determine, based on the detected temperature, whether an overheat condition has occurred,

In Figure 2, the controller 52 is connected with the display switch 32, the display 30, the memory 50, and the various sensors and detectors 42, 44, 46, 48, for communicating with the sensors and detectors 42, 44, 46, 48 for controlling a lighted state of the display 30 to progressively light the segments to represent different information.

By default, during normal use of the pack 10 when the pack 10 is attached to the power tool and when the power tool trigger is on (i.e. the tool is operating), the controller 52 controls the display 30 to operate in a current display state to indicate a level of current detected by the current sensor 44. The current display state remains active during use to provide an indicator to the user, unless the controller 52 determines that a change in display state is required.

When, during the current display state, the user actuates the momentary display switch 32 (e.g., by a single press, or by pressing and holding the switch for less than 10 seconds), the controller 52 identifies this as the a first display command and correspondingly switches the display 30 to a charge display state and controls the display 30 to indicate, for a predetermined duration (e.g., 2 seconds), a level of charge detected by the charge sensor 42. After the predetermined duration has elapsed, the controller reverts to the current display state, and will indicate (as described above) the level of current drawn by use of the power tool. The charge display state may differ from the current display state in respect of a colour of illumination of the segments of the display 30.

When, during the current display state, the user continuously actuates the display switch 32 for a period of time that is above a predetermined duration threshold (e.g., for 10 seconds), the controller 52 identifies the second display command and switches the display 30 to a cycle display state, and controls the display 30 to indicate, for a predetermined duration (e.g. 2 seconds), the level of the accumulated number of battery-charging cycles. The controller 52 communicates with the memory 50 in order to obtain the accumulated number of battery-charging cycles. After the predetermined duration has passed, the controller reverts to the current display state, and will indicate (as described above) the level of current drawn by use of the power tool. The cycle display state may differ from both the charge display state and the current display state in respect of a colour of illumination of the segments of the display 30.

During normal use, upon detection of an abnormal condition by the abnormality detector 46, the controller 52 switches the display 30 to an abnormality display state, and controls a lighted state of the segments of the display 30 to indicate the occurrence of the abnormality, providing a display that is different from both of that in the current display state and in the charge display state. The abnormality display state may differ from both the charge display state and the current display state in respect of a pattern of illumination of the segments. The abnormality display state may override the charge display state, the current display state, and the cycle display state, until the abnormal condition at the pack 10 is mitigated. In one example, the abnormality display state is maintained even after actuation of the display switch 32.

Details of an exemplary display pattern of the display 30 are further described with respect to Figure 3. As shown in Figure 3, the display 30 includes four like segments 30A-30D equally spaced from one another in a linear array. Each of the segments 30A-30D may be illuminated, statically or dynamically, in a different colour.

In operation, when the pack 10 is attached to the power tool and when the power tool trigger is on (i.e., operating), the controller 52 controls the display 30 to operate in a default current display state and acts as a load gauge. In the 58V pack of the present embodiment, when the current drawn from the pack 10 as determined by current sensor 44 is below 20A, none of the segments 30A-30D are lit up. When the current drawn from the pack 10 as determined by current sensor 44 is between 20A and 30A, the segment 30A is constantly lit up in orange. When the current drawn from the pack 10 as determined by current sensor 44 is between 30A and 40A, the segments 30A, 30B are constantly lit up in orange. When the current drawn from the pack 10 as determined by current sensor 44 is between 40A and 50A, the three segments 30A-30C are constantly lit up in orange. When the current drawn from the pack 10 as determined by current sensor 44 is above 50A, all four segments 30A-30D are constantly lit up in orange. In this current display state, when illuminated, the illumination colour and intensity remain generally constant. The controller 52 operates the display 30 in the current display state continuously during operation of the tool, unless it determines that a change in display state is required.

When, during normal operation when the display 30 is in the current display state, and the user momentarily actuates the display switch 32, the controller 52 switches the display 30 to a charge display state in which the display 30 acts as a fuel gauge for a predetermined time, preferably 2 seconds, and then reverts to current display state. In the 58V pack of the present embodiment, when the voltage level of the pack 10 as determined by the charge sensor 42 is below 49.5V, only the segment 30A is constantly lit up in green for the 2 seconds. When the voltage level of the pack 10 as determined by charge sensor 42 is between 49.5V and 52.28V, the two adjacent segments 30A, 30B are constantly lit up in green for the 2 seconds. When the voltage level of the pack 10 as determined by the charge sensor 42 is between 52.28V and 55.51V, the three segments 30A-30C are constantly lit up in green for the 2 seconds. When the voltage level of the pack 10 as determined by the charge sensor 42 is above 55.51V, all four segments 30A-30D are lit up constantly in green for the 2 seconds. In this charge display state, when illuminated, the illumination colour and intensity remain generally constant, but different from that in the current display state.

When, during normal operation when the display 30 is in the current display state, and the user actuates the display switch 32 for an extended period of time exceeding a predetermined threshold, say 10 seconds, the controller 52 switches the display 30 to a cycle display state in which the display 30 acts as a charging-cycle indicator for a predetermined time, preferably 2 seconds, and then reverts to current display state. When the accumulated number of charging cycles of the pack 10 as recorded in the memory 50 is less than 125 times, the segment 30A is constantly lit up in red for the 2 seconds. When the accumulated number of charging cycles of the pack 10 as recorded in the memory 50 is between 126 and 250 times, the two segments 30A, 30B are constantly lit up in red for the 2 seconds. When the accumulated number of charging cycles of the pack 10 as recorded in the memory 50 is between 251 and 325 times, the three segments 30A-30C are constantly lit up in red for the 3 seconds. When the accumulated number of charging cycles of the pack 10 as recorded in the memory 50 is between 326 and 500 times, all four segments 30A-30D are constantly lit up in red for the 2 seconds. When the accumulated number of charging cycles of the pack 10 as recorded in the memory 50 has exceeded 500 times, the segment 30A blinks in red colour for the 2 seconds while the other segments 30B-30D are off.

At any time during operation, when an abnormality condition is detected by the abnormality detector 46, the controller 52 is arranged to switch the display 30 to an abnormality display state, until the abnormal condition ceases. In other words, when an abnormality condition occurs and persists, actuation of the display switch 32 would not change the state of the display 30 to the current display state or the cycle display state. The abnormality display state may override each of the current display state, the charge display state, and the cycle display state, provided that the abnormality condition persists. In one example, when an over- or under-voltage condition is detected by the abnormality detector 46 and is communicated to the controller 52, the controller 52 operates the display 30 in the abnormality display state to continuously blink all the four segments 30A-30D of the display 30 in green, independent of the actuation of the display switch 32 and the operation status of the power tool. In another example, when an over-load condition is detected by the abnormality detector 46 and is communicated to the controller 52, the controller 52 operates the display 30 in the abnormality display state to continuously blink all four segments 30A-30D of the display 30 in orange, independent of the actuation of the display switch 32 and the operation status of the power tool. When an overheat condition is detected by the abnormality detector 46 and is communicated to the controller 52, the controller 52 operates the display 30 in the abnormality display state to continuously all four segments 30A-30D of the display 30 in red, of the input received at the display switch 32 and the operation status of the power tool. In one embodiment, when a cell imbalance condition is detected (e.g., impedance mismatch) by the abnormality detector 46 and is communicated to the controller 52, the controller 52 operates the display 30 in the abnormality display state to continuously lit up the four segments 30A-30D of the display 30 in alternating colours (e.g., green-orange-green-orange) to indicate that the battery pack 10 needs to be put into a charger for maintenance. It will be understood that the way in which the display of the battery pack is controlled to present information is not limited to the colour, pattern, and timing described above. Also, the battery pack of the present invention may have different chemistry, different nominal voltage(s), e.g., 18V, 36V, and / or different capacity, e.g., 1Ah, 2Ah.

Aspects of the present invention have been described by way of example only and it should be appreciated that modifications and additions may be made thereto without departing from the scope thereof, which is exclusively defined by the attached claim set.

## Claims

1. A rechargeable battery pack attachable to a power tool, the rechargeable battery pack comprising:
a rechargeable battery;
a display comprising an array of segments;
a charge sensor for sensing a charge level of the rechargeable battery;
a display switch that is user-actuable for inputting a first display command;
a current sensor for sensing a current level drawn from the rechargeable battery by the power tool;
an abnormality detector for detecting an abnormal condition of the rechargeable battery; and
a controller operably connected to the display, the charge sensor, the display switch, the current sensor, and the abnormality detector, for controlling a lighted state of the display to progressively light the segments to represent
i) in a charge display state, a level of charge detected by the charge sensor for a predetermined time, upon receiving the first display command, and
ii) in a current display state different from the charge display state, a level of current detected by the current sensor;
wherein the current display state is a default state active in the absence of an abnormality detected by the abnormality detector and in the absence of the first display command.

2. The rechargeable battery pack in accordance with claim 1, wherein the illuminated segments are continuously illuminated in each of the charge display state and the current display state, and the current display state differs from the charge display state in respect of a colour of illumination of each of the segments.

3. The rechargeable battery pack in accordance with claim 1, wherein the array of segments is a substantially linear array; and the progressively lighted segments form a bar graph type display.

4. The rechargeable battery pack in accordance with claim 3, wherein only a first of the segments, located at one end of the substantially linear array, is lighted in both the charge and current display states to indicate, respectively, a low charge level and a low current level.

5. The rechargeable battery pack in accordance with any one of claims 1-4, wherein the display switch is an instantaneous switch and the predetermined time after actuation of the display switch is less than four seconds.

6. The rechargeable battery pack in accordance with any one of claims 1-4, wherein the controller is further arranged to control a lighted state of the segments to represent, in an abnormality display state different from both the current display state and the charge display state, an abnormality condition of the rechargeable battery pack as detected by the abnormality detector; wherein the abnormality display state overrides the charge display state and the current display state.

7. The rechargeable battery pack in accordance with claim 6, wherein the abnormality display state differs from the charge display state and the current display state in respect of a pattern of illumination of the segments.

8. The rechargeable battery pack in accordance with any one of claims 1-4, wherein the rechargeable battery pack further comprises
a charge cycle detector for detecting a battery-charging cycle in which battery charge levels are raised between predetermined levels; and
a memory for recording an accumulated number of the battery-charging cycles;
wherein the display switch is user-actuable for inputting a second display command; and
wherein in a cycle display state, different from both the charge display state and the current display state, and upon receiving the second display command, the controller controls the lighted state of the display to progressively light the segments to represent the level of the accumulated number of battery-charging cycles; and
wherein the current display state is the default state active in the further absence of the second display command.

9. The rechargeable battery pack in accordance with claim 8, wherein the cycle display state differs from the charge display state and the current display state in respect of a colour of illumination of each of the segments.

10. The rechargeable battery pack in accordance with claim 8, wherein only the first of the segments is lighted in the cycle display state to indicate a low accumulated number of battery-charging cycles.

11. The rechargeable battery pack in accordance with claim 8, wherein the controller is arranged to distinguish between the first input command and the second input command based on a duration of actuation of the display switch.

12. The rechargeable battery pack in accordance with claim 11, wherein the controller is arranged
i) to determine that the first display command is received upon detecting actuation of the display switch for a first duration, and
ii) to determine that the second display command is received upon detecting actuation of the display switch for a second duration above a predetermined threshold duration that is longer than the first duration.

## Patentansprüche

1. Akku, der an einem Elektrowerkzeug angebracht werden kann, wobei der Akku umfasst:
eine wiederaufladbare Batterie;
eine Anzeige, die eine Anordnung von Segmenten umfasst;
einen Lade-Sensor zum Erfassen eines Ladepegels der wiederaufladbaren Batterie;
einen Anzeigeschalter, der von einem Benutzer betätigt werden kann, um einen ersten Anzeige-Befehl einzugeben;
einen Strom-Sensor zum Erfassen eines von dem Elektrowerkzeug aus dem Akku entnommenen Strompegels;
einen Störungs-Detektor zum Erfassen eines Störungszustandes der wiederaufladbaren Batterie; sowie
eine Steuerungseinrichtung, die funktional mit der Anzeige, dem Lade-Sensor, dem Anzeigeschalter, dem Strom-Sensor und dem Störungs-Detektor verbunden ist, um einen Leuchtzustand der Anzeige so zu steuern, dass die Segmente aufeinanderfolgend leuchten, um darzustellen:
i) in einem Lade-Anzeigezustand einen durch den Lade-Sensor über eine vorgegebene Zeit erfassten Ladepegel beim Empfangen des ersten Anzeige-Befehls, und
ii) in einem Strom-Anzeigezustand, der sich von dem Lade-Anzeigezustand unterscheidet, einen durch den Strom-Sensor erfassten Strom-Pegel;
wobei der Strom-Anzeigezustand ein Standardzustand ist, der bei Abwesenheit einer durch den Störungs-Detektor erfassten Störung und bei Abwesenheit des ersten Anzeigebefehls aktiv ist.

2. Akku nach Anspruch 1, wobei die leuchtenden Segmente sowohl in dem Lade-Anzeigezustand als auch in dem Strom-Anzeigezustand kontinuierlich leuchten und sich der Strom-Anzeigezustand von dem Lade-Anzeigezustand in Bezug auf eine Leuchtfarbe jedes der Segmente unterscheidet.

3. Akku nach Anspruch 1, wobei die Anordnung der Segmente eine im Wesentlichen lineare Anordnung ist; und die aufeinanderfolgend leuchtenden Segmente eine säulendiagrammartige Anzeige bilden.

4. Akku nach Anspruch 3, wobei nur ein erstes der Segmente, das sich an einem Ende der im Wesentlichen linearen Anordnung befindet, sowohl im Lade- als auch im Strom-Anzeigezustand leuchtet, um einen niedrigen Ladepegel bzw. einen niedrigen Strompegel anzuzeigen.

5. Akku nach einem der Ansprüche 1 - 4, wobei der Anzeigeschalter ein sofort ansprechender Schalter ist und die vorgegebene Zeit nach Betätigung des Anzeigeschalters weniger als vier Sekunden beträgt.

6. Akku nach einem der Ansprüche 1 - 4, wobei die Steuerungseinrichtung des Weiteren so eingerichtet ist, dass sie einen Leuchtzustand der Segmente so steuert, dass in einem Störungs-Anzeigezustand, der sich sowohl von dem Strom-Anzeigezustand als auch von dem Lade-Anzeigezustand unterscheidet, ein von dem Störungs-Detektor erfasster Störungszustand des Akkus dargestellt wird, wobei der Störungs-Anzeigezustand den Lade-Anzeigezustand und den Strom-Anzeigezustand übersteuert.

7. Akku nach Anspruch 6, wobei sich der Störungs-Anzeigezustand von dem Lade-Anzeigezustand und dem Strom-Anzeigezustand in Bezug auf ein Leuchtmuster der Segmente unterscheidet.

8. Akku nach einem der Ansprüche 1 - 4, wobei der Akku des Weiteren umfasst:
einen Ladezyklus-Detektor zum Erfassen eines Batterie-Ladezyklus, in dem die Batterie-Ladepegel zwischen vorgegebenen Pegeln angehoben werden; und
einen Speicher zum Aufzeichnen einer akkumulierten Anzahl der Batterie-Ladezyklen;
wobei der Anzeigeschalter von einem Benutzer betätigt werden kann, um einen zweiten Anzeigebefehl einzugeben; und
in einem Zyklus-Anzeigezustand, der sich sowohl von dem Lade-Anzeigezustand als auch von dem Strom-Anzeigezustand unterscheidet, und bei Empfangen des zweiten Anzeige-befehls die Steuerungseinrichtung den Leuchtzustand der Anzeige so steuert, dass die Segmente aufeinanderfolgend leuchten, um den Stand der akkumulierten Anzahl von Batterie-Ladezyklen darzustellen; und
der Strom-Anzeigezustand der Standardzustand ist, der beim weiteren Ausbleiben des zweiten Anzeigebefehls aktiv ist.

9. Akku nach Anspruch 8, wobei sich der Zyklus-Anzeigezustand von dem Lade-Anzeigezustand und dem Strom-Anzeigezustand in Bezug auf eine Leuchtfarbe jedes der Segmente unterscheidet.

10. Akku nach Anspruch 8, wobei nur das erste der Segmente in dem Zyklus-Anzeigezustand leuchtet, um eine niedrige akkumulierte Anzahl von Batterie-Ladezyklen anzuzeigen.

11. Akku nach Anspruch 8, wobei die Steuerungseinrichtung so eingerichtet ist, dass sie auf Basis einer Dauer von Betätigung des Anzeigeschalters zwischen dem ersten Eingabebefehl und dem zweiten Eingabebefehl unterscheidet.

12. Akku nach Anspruch 11, wobei die Steuerung so eingerichtet ist, dass sie
i) beim Erfassen von Betätigung des Anzeige-Schalters über eine erste Zeitdauer feststellt, dass der erste Anzeigebefehl empfangen wird, und
i) beim Erfassen von Betätigung des Anzeige-Schalters über eine zweite Zeitdauer, die über einer Schwellenwert-Zeitdauer liegt und länger ist als die erste Zeitdauer, feststellt, dass der zweite Anzeigebefehl empfangen wird.

## Revendications

1. Bloc-batterie rechargeable pouvant être fixé à un outil électrique, le bloc-batterie rechargeable comprenant :
une batterie rechargeable ;
un dispositif d'affichage comprenant un réseau de segments ;
un capteur de charge pour détecter un niveau de charge de la batterie rechargeable ;
un commutateur d'affichage qui peut être actionné par l'utilisateur pour entrer un premier ordre d'affichage ;
un capteur de courant pour détecter un niveau de courant absorbé de la batterie rechargeable par l'outil électrique ;
un détecteur d'anomalie pour détecter une condition anormale de la batterie rechargeable ; et
un dispositif de commande connecté de manière fonctionnelle au dispositif d'affichage, au capteur de charge, au commutateur d'affichage, au capteur de courant et au détecteur d'anomalie, pour commander un état éclairé du dispositif d'affichage pour éclairer progressivement les segments pour représenter
i) dans un état d'affichage de charge, un niveau de charge détecté par le capteur de charge pendant un temps prédéterminé, lors de la réception du premier ordre d'affichage, et
ii) dans un état d'affichage de courant différent de l'état d'affichage de charge, un niveau de courant détecté par le capteur de courant ;
dans lequel l'état d'affichage de courant est un état par défaut actif en l'absence d'une anomalie détectée par le détecteur d'anomalie et en l'absence du premier ordre d'affichage.

2. Bloc-batterie rechargeable selon la revendication 1, dans lequel les segments éclairés sont éclairés en continu dans chacun de l'état d'affichage de charge et de l'état d'affichage de courant, et l'état d'affichage de courant diffère de l'état d'affichage de charge en ce qui concerne une couleur d'éclairage de chacun des segments.

3. Bloc-batterie rechargeable selon la revendication 1, dans lequel le réseau de segments est un réseau sensiblement linéaire ; et les segments progressivement éclairés forment un affichage de type diagramme à barres.

4. Bloc-batterie rechargeable selon la revendication 3, dans lequel seul un premier des segments, situé au niveau d'une extrémité du réseau sensiblement linéaire, est éclairé à la fois dans les états d'affichage de charge et de courant pour indiquer, respectivement, un faible niveau de charge et un faible niveau de courant.

5. Bloc-batterie rechargeable selon l'une quelconque des revendications 1 à 4, dans lequel le commutateur d'affichage est un commutateur instantané et le temps prédéterminé après l'actionnement du commutateur d'affichage est inférieur à quatre secondes.

6. Bloc-batterie rechargeable selon l'une quelconque des revendications 1 à 4, dans lequel le dispositif de commande est en outre agencé pour commander un état éclairé des segments pour représenter, dans un état d'affichage d'anomalie différent à la fois de l'état d'affichage de courant et de l'état d'affichage de charge, une condition d'anomalie du bloc-batterie rechargeable telle que détectée par le détecteur d'anomalie ; dans lequel l'état d'affichage d'anomalie remplace l'état d'affichage de charge et l'état d'affichage de courant.

7. Bloc-batterie rechargeable selon la revendication 6, dans lequel l'état d'affichage d'anomalie diffère de l'état d'affichage de charge et de l'état d'affichage de courant en ce qui concerne un motif d'éclairage des segments.

8. Bloc-batterie rechargeable selon l'une quelconque des revendications 1 à 4, dans lequel le bloc-batterie rechargeable comprend en outre
un détecteur de cycle de charge pour détecter un cycle de charge de batterie dans lequel des niveaux de charge de batterie sont augmentés entre des niveaux prédéterminés ; et
une mémoire pour enregistrer un nombre cumulé de cycles de charge de batterie ;
dans lequel le commutateur d'affichage peut être actionné par l'utilisateur pour entrer un deuxième ordre d'affichage ; et
dans lequel, dans un état d'affichage de cycle, différent à la fois de l'état d'affichage de charge et de l'état d'affichage de courant, et lors de la réception du deuxième ordre d'affichage, le dispositif de commande commande l'état éclairé du dispositif d'affichage pour éclairer progressivement les segments afin de représenter le niveau du nombre cumulé de cycles de charge de batterie ; et
dans lequel l'état d'affichage de courant est l'état par défaut actif en l'absence supplémentaire du deuxième ordre d'affichage.

9. Bloc-batterie rechargeable selon la revendication 8, dans lequel l'état d'affichage de cycle diffère de l'état d'affichage de charge et de l'état d'affichage de courant en ce qui concerne une couleur d'éclairage de chacun des segments.

10. Bloc-batterie rechargeable selon la revendication 8, dans lequel seul le premier des segments est éclairé dans l'état d'affichage de cycle pour indiquer un faible nombre cumulé de cycles de charge de batterie.

11. Bloc-batterie rechargeable selon la revendication 8, dans lequel le dispositif de commande est agencé pour faire la distinction entre le premier ordre d'entrée et le deuxième ordre d'entrée sur la base d'une durée d'actionnement du commutateur d'affichage.

12. Bloc-batterie rechargeable selon la revendication 11, dans lequel le dispositif de commande est agencé
i) pour déterminer que le premier ordre d'affichage est reçu lors de la détection de l'actionnement du commutateur d'affichage pendant une première durée, et
ii) pour déterminer que le deuxième ordre d'affichage est reçu lors de la détection de l'actionnement du commutateur d'affichage pendant une deuxième durée supérieure à une durée seuil prédéterminée qui est plus longue que la première durée.
